# EUROPEAN PATENT APPLICATION

(11) **EP 0 696 740 A2**
(43) Date of publication of application: **14.02.1996**
(21) Application number: 95304821.2
(22) Date of filing: 11.07.1995
(51) Int. Cl.: G01R 19/25

(54) **Multimeter-like user interface for a graphical instrument**

(30) Priority: 08.08.1994 US 287380
(71) Applicant: FLUKE CORPORATION, Everett, Washington 98206-9090 (US)
(72) Inventor: Boyer, Kim R., Edmonds, WA 98206 (US); Holmdahl, Todd E., Bothell, WA 98012 (US); Jones, Kristin L., Seattle, WA 98117 (US); Shakeri, Mohammad, Edmonds, WA 98020 (US)
(74) Representative: Burke, Steven David

(57) **Abstract**

An interactive user interface for a graphical instrument allows the user to perform both multimeter-like functions and graphical functions simply and easily. Conventional "meter" test leads and receptacles couple measurement circuitry in the instrument to the signal being measured. A rotary switch is operable to select a measurement function while a keypad having "hard" and "soft" keys, is used to select operating modes. The hard keys are used to select a first operating mode that is independent of the selected measurement function and the soft keys are used to select a second operating mode that is dependent on the selected first operating mode. One hard key allows the user to select either numerical information about the parameter being measured or graphical information about the measurement. A display includes a graphics portion that presents information related to the selected measurement function and first operating mode. Menus are presented in another portion of the display that provide information related to the second operating modes. The receptacles, rotary switch, hard and soft keys, display and related information are presented to the user on a single plane for contemporaneous viewing.

## Description

### Background of the Invention

This invention relates generally to electronic test and measuring instruments, and more particularly, to user interfaces for such instruments.

Communication between an electronic measuring instrument and the person using the instrument occurs through the instruments' user interface. While user interfaces vary between different types of instruments, they basically include a combination of input and output components. The input components typically include switches and/or pushbuttons that are operated to provide instructions to the instrument, and test leads for coupling the instrument to the signal being measured. Output components typically include displays for providing a visual reading and/or annunciators for providing audible information. An instrument's user interface is also defined by the arrangement of these components.

The ease with which an instrument is made to perform its intended task, e.g., measuring a particular electrical parameter, is an important feature of that instrument, and the user interface plays a significant role in determining how easy and logical the operation of the instrument will be. For example, a complex user interface may prevent the effective use of a particular instrument, while a simple, easy to understand interface may result in an instrument that is easy to use and operate. To achieve this simplicity and ease of use, the user interface should be intuitive to the target group, i.e., the intended users of that particular type of instrument. In other words, the components, layout of the components and their functionality should be logical to and easily understood by the primary users of that particular type of instrument.

An example of one type of instrument that has adopted a relatively standard user interface is the portable digital multimeter, or DMM. A conventional DMM user interface includes input receptacles for receiving standard meter test leads, a large rotary switch for selecting a measurement function and a small display that presents a numerical readout of measurement information. Such a numerical display includes both textual and numerical information. The DMM user interface may also include one or more push buttons for making additional function selections. Often, these components of the user interface are located on the front panel of the instrument. A notable example of a DMM user interface is found in the 80 Series line of DMMs manufactured by Fluke Corporation, Everett, Washington, USA. This simple, easy to use interface has gained wide ranging acceptance by technicians, repairmen and other multimeter users.

There is a growing demand for multifunction instruments, such as DMMs, to perform an increasing number of functions. For example, in the case of DMMs, some of these "new" functions include waveform or other graphical functions that historically were performed by other types of instruments, such as oscilloscopes, strip chart recorders, power analyzers, spectrum analyzers and the like. In the past, efforts to provide these "graphical" instruments have resulted in instruments with unfamiliar and complex user interfaces. The complexity or "unfriendliness" is usually a result of combining different interfaces. For example, in the past, if oscilloscope functions were added to a DMM, the resulting instrument typically had a user interface that included portions of both DMM and oscilloscope interfaces. An example of such an instrument is the model M2050 Digital Scope Multimeter, by BBC-Metrawatt/Goerz of Germany. When using this type of instrument, a technician who has become comfortable with a DMM, and its user interface, must now use an oscilloscope-like interface in order to access some of the instrument's functions. The technician's unfamiliarity with the oscilloscope user interface will likely detract from efficient and proper use of the instrument.

Occasionally, a graphical instrument may be designed with an entirely new user interface that is significantly different than the user interfaces of the separate instruments whose functions were combined. An example of such an instrument is the ScopeMeter® test tool by Fluke Corporation. The user interface of the ScopeMeter instrument is unlike like those of standard digital storage oscilloscopes and conventional DMMs. Accordingly, it is not unusual for a technician who is comfortable with scopes and DMMs to have some degree of unfamiliarity with such a user interface.

Another disadvantage with many prior art instruments whose user interfaces are not intuitive to the target group of users, is that the functionality and/or arrangement of the user interface components requires the user to frequently refer to an operator's manual. Yet another problem is that a technician may choose to use multiple instruments with which she/he is familiar instead of a single instrument that is unfamiliar. In addition, prior art instruments often require the use of different types of input devices (i.e., test leads) for the different functions. In any event, the need to refer to operator manuals or use several instrument instead of one may reduce the technician's efficiency.

Accordingly, there is a need for a user interface that is suitable for use with a graphical instrument such as a multimeter having graphical functionality, e.g., waveform and graphics display capabilities, is simple to use and allows the user to quickly and easily access the instrument's functions. The present invention, directed to a multimeter-like user interface, is designed to achieve these results.

### Summary of the Invention

In accordance with the present invention, a multimeter-like user interface for a graphical instrument is provided. The user interface includes, a first function selector operable to select one of a plurality of measurement functions, input receptacles and test leads for providing the instrument with information about the signal being measured and a display for presenting graphical information related to the selected measurement function.

In accordance with further aspects of the present invention, the first function selector is a rotary switch having a plurality of positions corresponding to the plurality of measurement functions of the instrument, wherein the switch may be rotated to a particular position to select a desired measurement function.

In accordance with still further aspects of the present invention, the test leads are meter test leads of the sort typically associated with conventional multimeters and the input receptacles are suitable for receiving meter test leads.

In accordance with yet further aspects of the present invention, the multimeter-like user interface includes a second function selector preferably in the form of a keypad operable to select first and second operating modes, wherein the first operating mode is dependent on the selected measurement function and the second operating mode that is dependent on the selected first operating mode.

In accordance with yet further aspects of the present invention, the display includes a first portion for presenting graphical information related to the selected measurement function and the first operating mode, and a second portion for presenting information related to the second operating mode.

In accordance with still further aspects of the present invention, the rotary switch, keypad and display are located in a single plane for contemporaneous viewing by a person using the instrument.

As will be appreciated from the foregoing summary, the present invention provides a multimeter-like user interface for a graphical instrument.

### Brief Description of the Drawings

The foregoing and other advantages of this invention will become more readily appreciated as the same becomes better understood by reference to the following description of a preferred embodiment taken in conjunction with the accompanying drawings, wherein:
FIG. 1 is a simplified block diagram illustrating important features of the present invention;
FIG. 2 is a perspective view of a graphical instrument having a multimeter-like user interface on a single plane according to a preferred embodiment of the present invention; and,
FIGs. 3-8 are simplified, front elevational views of a portion of the user interface of FIG. 2 illustrating the presentation of information in the single plane for contemporaneous viewing.

### Detailed Description of the Preferred Embodiment

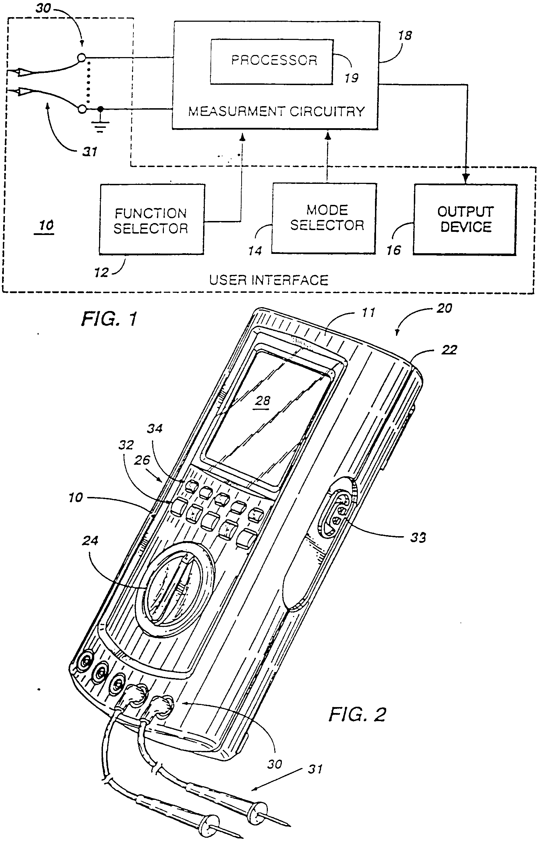

FIG. 1 illustrates in simplified block diagram form, a portion of an electronic instrument suitable for measuring an electrical signal and incorporating a user interface 10 according to the present invention. The signal that is to be measured or otherwise analyzed by the instrument is applied to input terminals 30 via test leads 31 which couple the signal to measurement circuitry 18. User interface 10 is coupled to permit communication between the instrument and a person operating the instrument. Measurement circuitry 18 preferably includes processor 19 for controlling functions of the measurement circuitry, including operations on the electrical signal being measured, which are based upon instructions provided to it via user interface 10. The output of the measurement circuitry is presented to output device 16. The particular nature of the output is determined by the operations performed by measurement circuitry 18 and by the instructions provided via user interface 10.

User interface 10 includes input terminals 30, test leads 31, function selector 12, and the output device 16. As will be discussed below, user interface 10 may- also include mode selector 14. Function selector 12 is operable to provide information to measurement circuitry 18, which causes the instrument to perform a particular function, or operation, on the signal being measured. The selected function is preferably a measurement function, such as voltage or current measurement, for example. Output device 16 provides information to the user and includes a display that is suitable for presenting graphical information related to the output of measurement circuitry 18. Such a display may also provide feedback to the user in the form of text or icons identifying the selected functions. In addition, output device 16 may include an annunciator that would provide audible feedback to the user. For example, the annunciator may confirm function selections or other events that take place during operation of the instrument by providing the user with distinct electronic beeps or chirps.

In accordance with a preferred embodiment of the present invention, user interface 10 includes mode selector 14 which is operable to provide information to measurement circuitry 18 so as to cause the instrument to operate in a particular mode. For example, the mode selector may select different display options, such as a particular graphical or numerical display of information on output device 16. Mode selector 14 is discussed more fully below.

In accordance with the preferred embodiment of the present invention, and as will be discussed more fully below, mode selector 14 allows the user to select between multimeter-like functions and graphical (e.g., oscilloscope-like) functions or a combination thereof. As defined herein, multimeter-like functions refers to and includes conventional multimeter functions such as the numerical and textual display of a measured parameter, e.g., voltage or current, while graphical functions refers to waveform displays of the measured parameter, trend plots of measurements, Lissajous pattems, logic activity graphs, etc. Thus, the user is able to select various measurement functions and both multimeter and graphical operating modes using a multimeter-like user interface.

An important feature of user interface 10 is that it resides in a single plane 11. As a result, the user is able to view contemporaneously function selector 12, mode selector 14 and output device 16 as well as associated information as it is presented in single plane 11. Input receptacles 30 are also preferably located in plane 11. As a result, the user is provided with information that may be viewed at a glance, which makes operation of the instrument simple and efficient. For example, a user is able to view selection choices without having to resort to using a "help" key or refer to an operator's manual. In addition, a person may at a glance, determine what functions may be selected, or what function or mode the instrument is presently in, without having to perform several key strokes or scrolling through different menus to get this information.

FIG. 2 illustrates a working model of the present invention as it is incorporated into the housing, namely, front panel 22, of graphical instrument 20. The signal which is to be measured is supplied to instrument 20 via conventional, meter test leads 31 which are connectable to input terminals 30. An RS 232 port 33 is provided for up loading or down loading information to be further processed. Instrument 20 is preferably a portable, electronic measurement instrument capable of operating as a conventional multimeter to make, for example, voltage and current measurements, and also as a graphical instrument capable of performing other functions such as displaying the waveform of the signal being measured or plotting samples of the signal over some time interval. As briefly discussed above, an important feature of the present invention, is that the user may access these meter and graphical functions through a user interface that is similar to a conventional multimeter user interface, such as the user interface found in the Series 80 line of multimeters manufactured by Fluke Corporation, Everett, Washington, USA

As depicted in FIG. 2, user interface 10 includes, within single plane 11, input receptacles 30, rotary switch 24 (function selector 12), keypad 26 (mode selector 14) and display 28 (output device 16). Rotary switch 24 has multiple positions and, preferably, is similar to rotary switches found on conventional digital multimeters, such as those found on the Fluke 80 Series multimeters. Keypad 26 preferably includes two rows of keys located in single plane 11 between rotary switch 24 and display 28. As oriented in FIG. 2, the keys of lower row 32 are adjacent rotary switch 24 and the keys of upper row 34 are adjacent display 28. Input receptacles 30 are adjacent rotary switch 24 opposite keypad 26.

As will be discussed more fully below, the keys of lower row 32 are "hard" keys that access operating modes of the instrument that are substantially independent of the measurement functions selectable with rotary switch 24. It will also be discussed more fully below that the operating modes accessible with the keys of upper row 34, which are "soft" keys, are dependent on the selections made with the hard keys of lower row 32. It is to be understood that the particular quantity and locations of the keys within single plane 11 are not critical to the present invention and that the particular quantities and locations described herein and illustrated in FIG. 2 are merely exemplary of keypad 26.

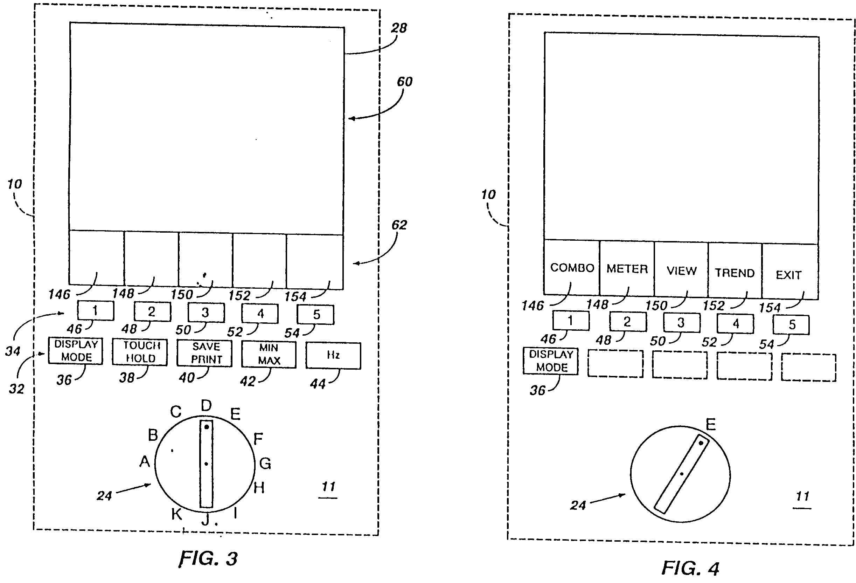

Portions of user interface 10 and single plane 11 are depicted in greater detail in FIG. 3. Measurement functions associated with the multiple positions of rotary switch 24 are represented in FIG. 3 by the letters A-K. Table 1 below sets forth the letters and corresponding measurement functions of the working model set forth in FIG. 2. The functions illustrated in Table 1 are presented for purposes of illustration, and are to be considered merely exemplary of other suitable measurement functions.

**TABLE 1**

| Switch Position | Measurement Function |
|---|---|
| A | Logic |
| B | Component Test |
| C | Set Up |
| D | Off |
| E | AC Volts |
| F | DC Volts |
| G | DC Millivolts/High Impedance |
| H | Ohms |
| I | Diode Test/Capacitance |
| J | AC/DC Amps |
| K | AC/DC Milli/Micro Amps |

Moving switch 24 to position A (Logic), places the instrument in a mode for monitoring the logic activity in a circuit under test. Likewise, placing switch 24 in position B (Component Test) puts the instrument in a mode for testing individual components, and position C (Set Up) places the instrument in a self test, or calibration, mode. Positions D-K represent well known, conventional multimeter functions and, hence, are not discussed herein in detail. Thus, the position of rotary switch 24 determines the particular measurement function to be performed by instrument 20.

The keys of key pad 26 are also depicted in greater detail in FIG. 3. Lower row 32 includes hard keys 36-44. As previously discussed, the operating modes associated with hard keys 36-44 are independent of the measurement functions (Table 1). Accordingly, each of the hard keys of row 32 is labeled with the particular operating mode that is accessible with that particular key. Labeling of the hard keys is as follows: key 36 - "Display Mode", key 38 - "Touch Hold", key 40 - "Save/Print", key 42 - "Min/Max", and key 44 - "Hz". Display Mode key 36 allows the user to select a particular mode for displaying information on display 28. Touch Hold key 38 allows the user to hold and display the held value of the signal being measured. Save/Print key 40 allows the user to print and/or save information appearing on display 28. Min/Max key 42 allows the user to display minimum and maximum values of the measured signal along with time stamping of the values. Hz key 44 allows the user to display frequency information for the signal being measured. The foregoing operating modes of keys 36-44 are provided for purposes of discussion and are merely examples of possible functions/modes that may be associated with the keys. Accordingly, it is understood that the particular functions, or set of functions, associated with the keys is not an important aspect of the present invention.

As further illustrated in FIG. 3, upper row 34 includes five soft keys 46-54, which preferably are not labeled with a particular function, but instead are labeled with numbers 1-5, respectively, hence the term "soft". The functions of soft keys 46-54 are dependent on the particular operating mode selected with hard keys 36-44 of lower row 32. Thus, for example, key 46 may access different instrument functions/operating modes depending on the selection made with keys 36-44. As will be discussed more fully below, the actual function assigned to keys 46-54 is presented on display 28.

Display 28 is preferably a liquid crystal display whose screen is oriented above and adjacent keys 46-54. In accordance with the commercial embodiment, display 28 is 200 by 240 pixel dot matrix display suitable for displaying graphical information such as waveforms, time interval data and the like. As such, display 28 is substantially larger than the displays of conventional DMMs and is capable of displaying real-time graphical information, unlike conventional DMMs. The screen of display 28 has an upper portion 60 and a lower portion 62. Preferably, numerical and waveform information is displayed in upper portion 60 while lower portion 62 is reserved for informational menus used to explain the functions of soft keys 46-54. Lower portion 62 is further divided into five areas 146-154 corresponding to keys 46-54, respectively. Each of the areas 146-154 corresponds to the key adjacent and directly below it as oriented in FIG. 3. As will be discussed more fully below, information is provided in each of areas 146-154 that describes the function/operating mode associated with the soft key adjacent that particular area of lower portion 62.

FIGs. 4-8 illustrate in greater detail, information presented by user interface 10 as it appears in single plane 11 for contemporaneous viewing by the user. For purposes of illustrating important features and the benefits of the present invention, the following function and operating mode are assumed to have been selected: AC voltage measurement (i.e., position E of rotary switch 24) and Display Mode (i.e., key 36). Hence, for ease of understanding and purposes of illustration, position labels A-D and F-K are omitted, and hard keys 38-44 are shown in phantom in FIGs 4-8. The resulting information, as it appears in single plane 11, is depicted in FIG. 4. Information appearing in areas 146-154 of display 28 represent different modes for displaying information in upper portion 60 of display 28. In particular, the following labels; "Combo", "Meter", "View", "Trend", and "Exit", appear in areas 146-154, respectively. Pressing any one of keys 46-54 will cause the instrument to enter the particular display mode corresponding to the label adjacent that key. Each of these display modes will now be discussed in more detail.

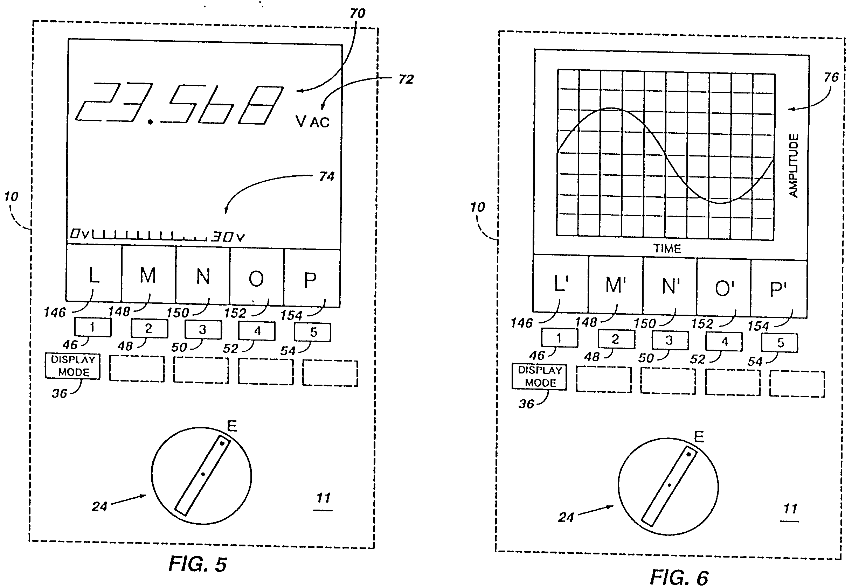

By pressing button 48 (Meter), the user activates the meter mode and causes the display to present information as depicted in FIG. 5. In keeping with the present example, the amplitude of the measured ac voltage is presented in the upper portion 60 of display 28 as a numerical readout 70 along with an icon 72 representing the selected measurement function. The measured value may also be presented in the upper portion of display 28 in the form of a bar graph or other analog-like representation 74. The information presented in the upper portion of display 28 in FIG. 5 is representative of displays found in conventional and well known digital multimeters, such as the Fluke 80 Series, for example.

In meter mode, the functionality of soft keys 46-54 are represented by labels L-P in areas 146-154, respectively. More specifically, and in accordance with the commercial embodiment, labels for keys 146-154 are as follow: key 146 (L) - "Relative Mode", key 148 (M) - "Peak Hold", key 150 (N) - "RMS/Average", key 152 (O) - "dB", and key 154 (P) - "Auto". Thus, by pressing the above keys the user activates the foregoing operating modes and as a result may view, respectively, relative changes in measured values, peak values, the "root mean squared" or average values, the power of the measured value and either select or deselect default values of the instrument.

In order to look at the waveform of the ac voltage being measured, the user simply presses key 50 (View) to enter the view, or waveform, mode as illustrated in FIG. 6. In this oscilloscope-like mode, a graphical representation 76 of the voltage waveform is presented in the upper portion of display 28. Thus, in the view mode the user is provided with additional information about the signal being measured. For example, the shape of the signal's waveform may provide harmonic information and evidence of "noise" not normally available with the numerical display of FIG. 5.

In view mode, the functionality of soft keys 46-54 are represented by labels L'-P' in areas 146-154, respectively. More specifically, the labels for keys 146-154 are as follow: key 146 (L') - "Time Base", key 148 (M') - "Trigger", key 150 (N') - "Single Shot", key 152 (O') - "Glitch Capture", and key 154 (P') - "Auto". Thus, by pressing the above keys, the user activates the corresponding operating mode permitting the selection of, respectively, time base values, trigger points, sampling continuous or single shot waveforms, a fast glitch capture mode and default values of the instrument.

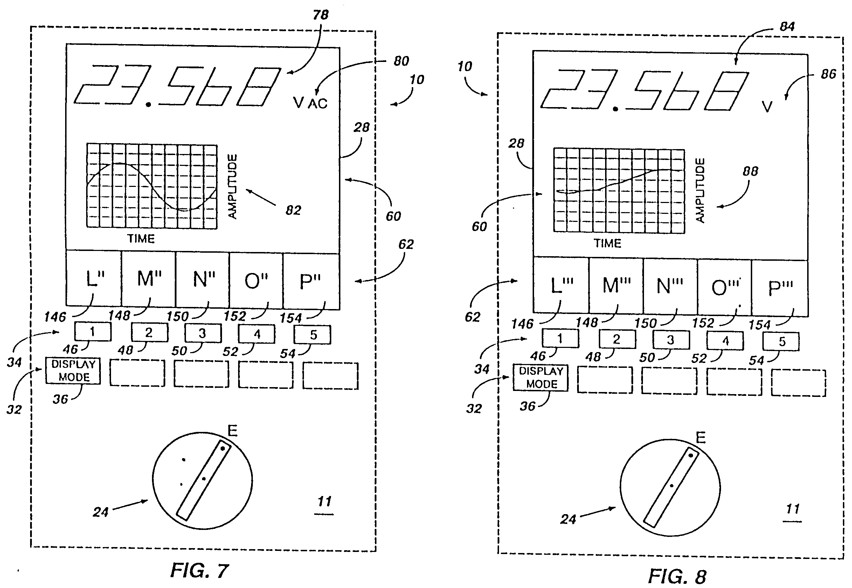

Pressing button 46 (Combo) causes the instrument to combine the information from the meter and view modes and present it on display 28 as illustrated in FIG. 7. In this combination mode, both waveform and numerical representations of the voltage signal are presented in upper portion 60 of the display 28. More particularly, a numerical representation 78 along with icon 80 are presented near the top of upper portion 60 and a graphical representation 82 is presented near the bottom of upper portion 60. Comparing FIGs 6 and 7, it is apparent that graphical representation 76 fills a larger portion of display 28 than does graphical representation 82. Thus, while the combination mode provides the user with the convenience of having both numerical and waveform simultaneously, the view, or waveform, mode has the advantage of providing a larger display of the waveform, making the detection of some conditions easier. In accordance with the commercial embodiment of the present invention, the combination mode is the "default" mode of the instrument. As such, the instrument enters this mode when it is turned on, thus allowing the user to operate the instrument like a conventional DMM while having the additional benefit of receiving graphical information. In any event, the user has the ability to select the particular mode best suited for a specific application.

In the combination mode, functionality of soft keys 46-54 are represented by labels L''-P'' in areas 146-154, respectively. More specifically, labels for keys 146-154 are as follow: key 146 (L") - "Relative Mode", key 148 (M") - "Peak Hold", key 150 (N'') - "RMS/Average", key 152 (O'') - "dB", and key 154 (P'') - "Auto". Thus, by pressing the above keys, the user may activate operating modes similar to those discussed above with for the meter mode.

Pressing button 52 causes the display to enter the trend mode, whereby samples of the voltage signal are plotted against time to form an elapsed-time graph 76 of the ac voltage as depicted in FIG. 8. In particular, a numerical representation 84 along with icon 86 are presented near the top of upper portion 60 and a graphical representation, or trend plot, 88 is presented near the bottom of upper portion 60. The information presented in the trend mode is similar to the information provided by a strip chart recorder.

In trend mode, functionality of soft keys 46-54 are represented by labels L‴-P‴ in areas 146-154, respectively. More specifically, labels for keys 146-154 are as follow: key 146 (L‴) - "Enable RS232", key 148 (M‴) - "Time Longer", key 150 (N‴) - "Time Shorter", key 152 (O‴) - "Trend Type", and key 154 (P‴) - "Restart Trend". Thus, by pressing the above keys, the user may activate the foregoing operating modes and, respectively, enable transmission/reception of data over an RS232 port, increase or decrease the trend interval, or restart the trending process.

The foregoing discussion of one particular operating mode, namely, display mode, is intended to be illustrative of the various other modes of the instrument which are accessible by the user interface of the present invention. Accordingly, the foregoing description is representative of other operating modes accessible by soft keys 46-54 as they relate to different mode selections made with hard keys 36-44. Hence, a detailed discussion of the other possible modes selectable with soft keys 46-54 is not provided herein. Likewise, further detailed discussions of other measurement functions selectable with rotary switch 24 and operating modes selectable with hard keys 38-44 are not discussed herein in detail.

As can be appreciated from the foregoing discussion and with reference to FIGs. 4-8, the user interface of the present invention provides the user with a multimeter-like interface that allows information to be displayed either in a multimeter-like format (i.e., numerically via meter mode), in an oscilloscope-like format (i.e. graphically via waveform mode), in a strip chart-like format (i.e., graphically via trend plot mode) or in a combination mode (i.e., numerically and graphically via the combo mode). Other display modes are possible and are limited only by the hardware and software capabilities of the instrument.

Accordingly, a graphical instrument 20 such as the one depicted in FIG. 2 which incorporates the user interface 10 of the present invention, allows a user who is comfortable with the user interface of conventional digital multimeters to easily access the meter and graphical functionality of the instrument, via a multimeter-like user interface. Further, the multimeter-like user interface of the present invention permits the user to obtain numerical and textual information as well as graphical information using inexpensive meter test leads.

While a preferred embodiment of the present invention has been illustrated and described, it will be apparent to those skilled in the art that many changes and modifications may be made without departing from the invention in its broader aspects. For example, output device 16 may also include an annunciator circuit for providing audible feedback to the user. The audible feedback may be a variety of different beeps and chirps indicating different selections made by the user or different events, such as the detection of a new minimum or maximum value, for example. Also, functions and operating modes other than the ones specifically discussed herein could be easily accessed via the user interface of the present invention. Consequently, the invention can be practiced otherwise than as specifically described herein.

## Claims

1. A user interface for a graphical instrument comprising:
(a) input means for coupling an electrical signal to be measured with measurement circuitry of the instrument;
(b) a rotary switch coupled to said measurement circuitry and operable to select a measurement function of the instrument, whereby the instrument produces information related to said electrical signal; and,
(c) a display coupled to receive said information and present said information in at least one of numerical and graphical forms.

2. A user interface according to claim 1, wherein said input means comprises:
(a) a plurality of input receptacles coupled to said measurement circuitry; and,
(b) "meter" test leads having first ends coupleable to said input receptacles and second ends coupleable to receive said electrical signal.

3. A user interface according to claim 1, wherein said display comprises:
(a) a first portion for displaying graphical information related to said electrical signal; and,
(b) a second portion for presenting textual information related to the operation of the instrument.

4. A multimeter-like user interface for a graphical instrument having measurement circuitry for processing a signal to be measured, said multimeter-like user interface comprising:
(a) a function selector coupled to said measurement circuitry and operable to select one of a plurality of measurement functions of the instrument;
(b) a mode selector coupled to said measurement circuitry and operable to select a first operating mode of the instrument, wherein said first operating mode is independent of said selected measurement function; and,
(c) output means for presenting information related to the signal being measured, wherein said information is presented in at least one of numerical, textual and graphical forms, wherein said function selector, mode selector, output means and information presented by said output means is presented on a single plane suitable for contemporaneous viewing.

5. A multimeter-like user interface according to claim 4, wherein said mode selector comprises a keypad having at least one hard key operable to select said first operating mode of the instrument.

6. An interactive user interface according to claim 5, wherein said keypad further comprises at least one soft key for selecting a second operating mode of the instrument, wherein said selected second operating mode is dependent on said selected first operating mode of the instrument.

7. A multimeter-like user interface according to claim 6, wherein said output means includes a display comprising:
(a) a first screen portion for presenting said information related to the signal being measured; and,
(b) a second portion for presenting information related to said second operating mode.

8. In a graphical instrument suitable for measuring parameters of an electrical signal and having a case with a front panel, a multimeter-like user interface comprising:
(a) a rotary switch adjacent said front panel, said rotary switch having a plurality of switch positions corresponding to multiple measurement functions of said instrument and being operable to select one of said multiple measurement functions;
(b) a first set of keys adjacent said front panel and said rotary switch, said first set of keys being operable to select one of a first plurality of operating modes of the instrument, wherein each of said first plurality of operating modes is independent of the selected one of said multiple measurement functions;
(c) a second set of keys adjacent said front panel and said first set of keys, said second set of keys being operable to select one of a second plurality of operating modes of the instrument, wherein each of said second plurality of operating modes is dependent on the selected one of said first plurality of operating modes; and,
(d) a display adjacent said front panel and said second set of keys for presenting information related to the parameters of the electrical signal being measured in an upper portion of said display and for presenting information related to a selected one of said second plurality of operating modes in a lower portion of said display, said lower portion being in juxtaposition with said upper portion of said display and said second set of keys.

9. A measuring instrument having a function selector for selecting between a plurality of measurement functions, a display means having a first part for displaying a measurement derived according to the selected function and a plurality of mode keys arranged in proximity to a second part of the display means, each mode key being operable for selecting a respective one of a set of operating modes, the instrument being operable to alter the set of operating modes associated with the mode keys and the second display part having a plurality of regions each associated with a respective mode key for displaying information relating to the operating mode of the current set which is selectable by operation of the associated mode key.
